# EUROPEAN PATENT APPLICATION

(11) **EP 1 900 461 A1**
(43) Date of publication of application: **19.03.2008**
(21) Application number: 06745745.7
(22) Date of filing: 27.04.2006
(51) Int. Cl.: B22F 1/00, B22F 9/24, H01B 1/00, H01B 1/22

(54) **TIN POWDER, PROCESS FOR PRODUCING TIN POWDER, AND TIN POWDER-CONTAINING ELCTRICALLY CONDUCTIVE PASTE**

(30) Priority: 27.04.2005 JP 2005129669
(71) Applicant: MITSUI MINING & SMELTING CO., LTD., Tokyo 141-8584 (JP)
(72) Inventor: SAKAUE, Takahiko, Hikoshima Smelting Co. Ltd. Eng., Shimonoseki-s., Yamaguchi 750-0093 (JP); FURUMOTO, Keita, Hikoshima Smelting Co. Ltd. Eng., Shimonoseki-s., Yamaguchi 750-0093 (JP); YOSHIMARU, Katsuhiko, Hikoshima Smelting Co. Ltd., Shimonoseki-sh., Yamaguchi 750-0093 (JP)
(74) Representative: Bohmann, Armin K.
(86) International application number: PCT/JP2006/308817
(87) International publication number: WO 2006/118182

(57) **Abstract**

Object of the invention is to provide a tin powder containing fine tin particles which performs fine pitch wiring circuit easily, excellent in filling the minute diameter via holes, and exhibits low temperature fusibility. In order to achieve the object, a copper powder slurry is prepared by adding a copper powder in water with agitation and a tin solution for deposition by substitution is prepared by adding an acid to an aqueous mixture solution containing a stannous salt and thiourea. Then the copper powder slurry and the tin solution for deposition by substitution are mixed with agitation in a certain ratio of tin in the solution against to copper in the slurry to deposit tin by substitution on the surface of the copper powder. As a result, the tin powder of the present invention is obtained.

## Description

### Technical Field

The present invention relates to a tin powder, a manufacturing method of the tin powder and a conductive paste containing the tin powder. More specifically, the present invention relates to a tin powder which can be replaced with solder powder and for which both miniaturization with sharp particle size distribution of the tin powder that cannot be achieved in conventional solder powders have performed, a manufacturing method of the tin powder and a conductive paste using the tin powder.

### Background Art

Conventionally, solder powders as disclosed in Patent Document 1 have been widely used for filling via holes of a multilayered printed wiring board and as a powder constituting a conductive adhesive used for positioning electronic components such as IC devices and chip capacitors when they are mounted on a printed wiring board.

However, a eutectic solder composed of 63 wt% tin and 37 wt% lead is popular in solders, but lead contained in devices for consumer use products and the other electronics apparatuses may cause environmental problems, and therefore lead-free solder which contains no lead has been becoming predominantly used.

Meanwhile, solder powder has been generally manufactured by an atomization process conventionally as shown in Patent Document 2. The solder powder by the atomization process has an advantage that it is excellent in dispersibility in comparison with particles obtained by a wet process.

[Patent Document 1] Japanese Patent Laid-Open No. 10-058190 [Patent Document 2] Japanese Patent Laid-Open No. 2000-15482

### Disclosure of the Invention

However, the solder powder or tin powder (hereinafter generically referred to as "solder powder and the like".) obtained by the atomization process has a drawback that the particle size distribution is extremely broad. This is because the solder powder and the like by the atomization process contain a plenty of coarse particles as compared with the target particle size. In addition, the solder powder and the like generally have limitations of the particle size distribution which fall in the range of 1-micron meter to 10-micron meter when the particles as the constituent element are miniaturized. It is thus difficult to obtain fine particles without coarse particles and have an average particle diameter D_{IA} of 3-micron meter or less by the atomization process. And the following problems are resulted from such solder powder and the like having a broad particle size distribution and an average particle diameter exceeding 3-micron meter.

First, conductive pastes using the solder powder and the like having a broad particle size distribution and an average particle diameter exceeding 5-micron meter as the materials are difficult to be used for the formation of the fine circuits and the filling of small via holes (particularly in the case that the inside diameter is less than 100-micron meter). Next, as for recent copper powder for similar usage, those having an average particle diameter of 5-micron meter or less, sometimes 1-micron meter or less are supplied. Under such present situation, the solder powder and the like obtained by the conventional atomization process has difficulty in the formation of fine circuits to be equal or superior to that of the recent above-described copper powders or better filling of small via holes with regard to the above problems.

In particular, a multilayered printed wiring board has tendency to decrease the inner diameter of via holes as small as 150-micron meter, 70-micron meter, 50-micron meter or even less than 30-micronmeter depending on downsizing of electronic equipment these days. It is believed that such tendency will continue in the future. However, the solder powder and the like obtained by the atomization process contains plenty of coarse particles. So, the filling of via holes of a multi-layer printed wiring board, which are going to finer, is becoming more and more difficult. Such drawback is similar in the case of a powder mixture in which the solder powder and the like obtained by the atomization process are mixed with the other powder such as copper powder.

Therefore, solder powder or a substituting powder thereof which are fine particles and having a sharp particle size distribution able to be used for the formation of fine circuit and the filling of small via holes as described above are required.

Therefore, the present inventors have conducted intensive studies and consequently achieved the following tin powder preferable for replacing the solder powder and the like obtained by the conventional atomization process which can perform the formation of fine circuit and the filling of small via holes, a manufacturing method thereof and a conductive paste containing the tin powder.

### <Spherical tin powder>

The present invention provides a tin powder comprising spherical particles usable as a substitute for solder powder characterized in that D_{IA} is 0.1-micron meter to 3-micron meter and SD/D_{IA} is 0.1 to 0.3. Here, D_{IA} is an average value (average particle diameter) of particle diameters (micron meter) of tin powder measured from SEM images. SD/D_{IA} is a coefficient of variation which indicates sharpness or broadness of the particle size distribution.

It is preferable in the tin powder comprising spherical particles of the present invention that the value obtained by dividing the difference between the maximum particle diameter and the minimum particle diameter (range) by D_{IA} is 0.3 to 1.6.

### <Flaky tin powder>

The present invention provides a tin powder comprising flaky particles usable as a substitute for solder powder characterized in that D_{IAF} is 0.1-micron meter to 5-micron meter and SD/D_{IAF} is 0.15 to 0.4. Here, D_{IAF} refers to an average value of the major axis diameter (micron meter) of tin powder measured from SEM images. SD/D_{IAF} refers to a coefficient of variation which indicates sharpness or broadness of the particle size distribution.

It is preferable in the tin powder comprising flaky particles of the present invention that the value obtained by dividing the difference between the maximum particle diameter and the minimum particle diameter (range) by D_{IA} is 0.3 to 1.6.

In addition, it is preferable in the tin powder comprising flaky particles of the present invention that the value obtained by dividing the difference between the maximum particle diameter and the minimum particle diameter (range) by D_{IAF} is 0.3 to 1.6.

Furthermore, it is preferable in the tin powder comprising flaky particles of the present invention that the average aspect ratio of the tin powder particles is 2 to 10.

### <Manufacturing method of tin powder>

For the manufacturing method of the tin powder according to the present invention, it is preferable to adopt a manufacturing method containing the following Step a to Step c.

Step a: prepare a copper powder slurry having a dispersed copper concentration of 0.05-mol/L to 2-mol/L by adding a copper powder in water with agitation;
Step b: prepare a tin solution for deposition by substitution with temperature at 30-deg. C to 80-deg. C by adding an acid to a aqueous mixture solution containing 0.01-mol/L to 1-mol/L of a stannous salt and 0.1-mol/L to 10-mol/L of thiourea to arrange pH at 0.1 to pH 2; and
Step c: perform deposition of tin by substitution by mixing the copper powder slurry and the tin solution in the ratio of tin 0.4-mol to 1-mol against 1-mol of copper in the above copper powder slurry for deposition by substitutionwhile dispersing and agitating.

In the manufacturing method of the tin powder according to the present invention, it is preferable that the operation of mixing the above tin solution to above copper powder slurry for deposition by substitution while agitating is separately performed in plural times in the Step c. And the plural times is preferably three times or more.

In the manufacturing method of the tin powder according to the present invention, it is preferable that tin is substitution-deposited while applying vibration of ultrasound to the reaction slurry in the Step c.

The present invention provides a powder mixture characterized in that it is a mixture of the tin powder described above and powder of a conductive metal other than tin.

The present invention provides a conductive paste characterized by containing any of the tin powders described above.

The present invention provides a conductive paste characterized by containing the powder mixture described above.

Since the tin powder of the present invention comprising fine particles with sharp particle size distribution, in particular, it enables formation of conductive wirings which has tendency of pitch finer and finer, and forming of a connection in via holes which has tendency of diameter smaller and smaller.

### Brief Description of the Drawings

Figure 1 is an SEM image of a spherical tin powder of Example 1 according to the present invention (2,000 times magnification);
Figure 2 is an SEM image of a spherical tin powder of Example 2 according to the present invention (5,000 times magnification);
Figure 3 is an SEM image of a spherical tin powder of Example 3 according to the present invention (10,000 times magnification);
Figure 4 is an SEM image of a flaky tin powder of Example 4 according to the present invention (5,000 times magnification); and
Figure 5 is an SEM image of a tin powder by atomization process of Comparative Example according to conventional art (2,000 times magnification).

### Best Mode for Carrying Out the Invention

Hereinafter, embodiments for manufacturing of the tin powder of the present invention are described in following order. Spherical tin powder, flaky tin powder, manufacturing methods of the tin powders, metal mixture powders containing the tin powder, conductive pastes containing the tin powder, and conductive pastes containing a metal mixture powders of the tin powder and a metal powder. Then Examples and Comparative Examples will be described with total performance. Generally speaking, tin powder has characteristics that it does not results environmental problems as different from solder powder containing lead, and has capability for connecting close to solder powder at low temperature also.

### <Tin powder comprising spherical particles according to the present invention>

The tin powders comprising spherical particles (hereinafter simply referred to as "spherical tin powder".) according to the present invention are those having powder properties: (1) D_{IA} of 0.1-micron meter to 3-micron meter and (2) SD/D_{IA} of 0.1 to 0.3.

The spherical tin powder of the present invention is a spherical tin powder manufactured by using a copper powder as a raw material (base powder) by a wet substitution process. But it hardly contains residual un-substituted copper. If any, content may be generally 3 wt% or less. The content of the copper component remaining in the tin powder is determined by analyzing the copper component by ion plasma emission spectral analysis (ICP method) in hydrochloric acid after dissolving the powder sample in an acid.

One of the characteristics of the spherical tin powder according to the present invention: (1) "D_{IA} is 0.1-micron meter to 3-micron meter" will be described. More specifically, the "D_{IA}" described here is a value determined by image analysis (taken at 2,000 times to 10,000 times magnification in the present invention (see figures described later)) by circle particle analysis using IP-1000PC manufactured by Asahi Engineering Co., Ltd. and performing and assuming the circle degree threshold to be 50 to 70, and the overlapping degree to be 50 on the observed image of the copper powder with a scanning electron microscope (SEM).

Since the spherical tin powder of the present invention has the D_{IA} of 0.1-micron meter to 3-micron meter, it can achieve the formation of fine circuits whose production is said to be impossible according to the atomization process of the conventional art, and the filling of small via holes. Furthermore, since the tin powder of the present invention is a spherical tin powder whose particle diameter is even, it is easy to achieve the closest packing easily. In addition, since the fluidity of the spherical tin powder is good, it is easily made into a paste and suitable for forming wiring on fine circuits and for connecting in small via holes.

The present invention specifies the "average particle diameter D_{IA}" of the spherical tin powder as "0.1-micron meter to 3-micron meter". The manufacturing of powder having uniform and even particle diameter could not be achieved by the atomization process for such particle diameters. It may meet current market requirements.

When the D_{IA} of the spherical tin powder according to the present invention is equal to or less than the upper limit "3-micron meter", filling capability of the small via holes with diameter of around 50-micron meter are further improved and the resistance for shrinkage is also remarkably improved. On the other hand, with regard to the lower limit "0.1-micron meter", since there is a tendency that the particle size of the powder contained therein decreasing results increasing of the viscosity of a conductive paste and handling thereof might be more difficult in general. So, when a value D_{IA} is less than 0.1-micron meter, the viscosity of the conductive paste manufactured with the powder increases remarkably and the change of the viscosity with time become large. Then both of the handling and the management of the conductive paste might be complicated.

Next, another characteristic of the spherical tin powder according to the present invention: (2) described above "SD/D_{IA} is 0. 1 to 0.3" is described. Here, the "SD /D_{IA}" is a parameter showing sharpness and broadness of particle size distribution, and it is shown that the particle size distribution is sharper as SD/D_{IA} is smaller. This is the range that the atomization process could not achieve, and due to the sharpness of the particle size distribution, the viscosity of a paste formed by the spherical tin powder could be lower. Together due to the fine particle diameter, good filling capability of via holes of the printed wiring board and the formation of fine wiring can be achieved. When SD/D_{IA} exceeds the upper limit of 0.3, a lot of coarse particles and fine particles are contained, it is not preferable. On the other hand, it is difficult to manufacture tin powder containing fine particles smaller than the lower limit of 0.1. Sharpness of the particle size distribution may be further arranged by a classification finishing, but it makes the process complicated and remarkably deteriorates productivity, so it is not preferable.

Besides, as for the spherical tin powder according to the present invention, the value obtained by dividing the difference between the maximum particle diameter and the minimum particle diameter (range) by D_{IA} is preferably 0.3 to 1.6. That is, the index value is used as an index that can evaluate the particle size distribution which varies depending on the particle diameter relatively, and independently from the particle size.

It can be said that as the above value is smaller, the particle size distribution is sharper. The upper limit is 1.6, and this is because if the value is more than the upper limit, coarse particles are apparently supposed to be contained judging from the average particle diameter, which is not preferable. On the other hand, to achieve sharpness in the particle size distribution less than the lower limit of 0.3 causes increase in the production cost, so it is not practical.

### <Tin powder comprising flaky particles of the present invention>

Tin powder comprising flaky particles (hereinafter simply referred to as "flaky tin powder".) according to the present invention has powder properties of (1) D_{IAF} of 0.1-micron meter to 5-micron meter and (2) SD/D_{IAF} of 0.1 to 0.4. Thus, the formation of fine circuits and the filling of small via holes can be improved. D_{IAF} of the flaky tin powder according to the present invention falls within the range of 0.1-micron meter to 5-micron meter, a particles with such particle diameter has never been achieved conventionally and it may meet a current market requirements. If D_{IAF} of the flaky powder particle exceeds 5-micron meter, filling capabilities for small via holes remarkably deteriorates, so secured interlayer connection cannot be obtained. However, if D_{IAF} decreases to 5-micron meter or less, preferably 3 -micron meter or less, filling capabilities for small via holes of around 50-micron meter in diameter are improved drastically, and the shrinkage at the time of sintering does not result a problem. If the value is less than the lower limit 0.1-micron meter, viscosity of a conductive paste obtained therefrom tends to increase and the handling thereof tends to be difficult. In addition, it results change of the viscosity with time large, and both the handling and the management of the conductive paste might be complicated. Here, D_{IAF} is a value determined as an average value of the longer axis diameter of the flaky powder particles (n = 30) measured from SEM images.

Next "SD /D_{IAF} is 0.1 to 0.4" of the above described (2) is described. The "SD /D_{IAF}" is a parameter which indicates sharpness and broadness of size distribution of flaky tin powder, and it is showing that the particle size distribution is sharper as SD/D_{IAF} is smaller. When this value exceeds 0.4, coarse particles are contained, so it is not preferable. Therefore, specified upper limit of SD/D_{IAF} is 0.4 in the present invention. This range indicates sharpness of the particle size distribution of the flaky tin powder of the present invention. Meanwhile specified lower limit is 0.1. The value which is supposed to be practically impossible to further sharpen the particle size distribution based on experience and experiments of the inventors is determined to be the lower limit. Because, as described later, particles may deposit by substitution while stacking each other when they are manufactured and there is unevenness in temperature in the processing tank. Sharpness of the particle size distribution may be further achieved by classification finishing, but it makes the process complicated and remarkably deteriorates productivity, so it is not preferable.

In addition, when the shape stability of circuits or the like is required at a higher level in the wiring formation, inparticular, it is recommended to prepare and use a conductive paste with thixotropic properties using flaky tin powder.

As described above, it can be said by the characteristics (1) and (2) described above that the flaky tin powder of the present invention has an average particle diameter more minute than that of solder powder obtained by the conventional atomization process and also has a narrower particle size distribution.

And the tin powder of the present invention is preferably a flaky tin powder characterized in that the value obtained by dividing the difference between the maximum particle diameter and the minimum particle diameter (range) by D_{IAF} is 0.3 to 1.6. That is, the index value is used as an index that can evaluate the particle size distribution which varies depending on the particle diameter relatively, and independently from the particle size.

It can be said that as the above value is smaller, the particle size distribution is sharper. The upper limit is 1.6, and this is because if the value is more than the upper limit, coarse particles are apparently supposed to be contained judging from the average particle diameter, it is not preferable. On the other hand, sharpness of the particle size distribution having the lower limit less than 0.3 has not been achieved by the current manufacturing technology.

Furthermore, in the present invention, a flaky tin powder described above preferably has the average aspect ratio of 2 to 10. When the average aspect ratio is less than 2, flatness of the flaky tin particles is poor and show properties similar with the spherical tin powder. So, a conductive paste formed therefrom is poor in thixotropic characteristic in terms of the viscous performance, and results the tendency that the film density be lower and electrical resistance be higher remarkably. On the other hand, when the average aspect ratio exceeds 10, the flatness of the flaky tin particles is too high, and results broad particle size distribution and too thin thickness of the particles. As a result, the stability of the viscosity of a paste prepared therefrom decreases and uniform mixing with an organic vehicle which is a binder resin be difficult, so it is not preferable. Here, the "average aspect ratio" is a value calculated by [length of the longer axis]/[thickness], and it is an average value of the aspect ratio obtained from 30 particles in certain area of a SEM image.

### <Manufacturing method of the tin powder of the present invention>

The manufacturing method of the tin powder of the present invention applies a wet substitution process comprising contacting a copper powder slurry with a tin solution for deposition by substitution to dissolve a copper component constituting a copper powder and deposit tin by substitution at the same time and thereby manufacture tin powder having the above powder properties. And, the manufacturing method of the present invention is characterized by containing Step a to Step c. Each of the steps is described independently below.

Step a: This step prepare a copper powder slurry having a dispersed copper concentration of 0.05-mol/L to 2-mol/L by adding a copper powder in water with agitation. Here, a copper powder as a starting raw material is made into a slurry, and the copper powder is preferably a fine powder (primary average particle diameter; D_{IA} of 0.1-micron meter to 3.2-micron meter) having a sharp particle size distribution. The range of the primary average particle diameter of the copper powder concerned is set to be substantially the same as the range of a primary average particle diameter of the tin powder corresponding to smaller via holes and finer pitch in the conductive wirings. This is because the manufacturing method of the tin powder of the present invention is based on the process deposition by substitution in which a fine copper powder is used as an base powder and the copper is substituted with tin. The copper powder in a spherical or flaky shape is used respectively for forming spherical or flaky tin powder. The flaky tin powder can be also prepared by preparing a spherical tin powder and then smashing it up mechanically. In particular, the tin constituting the tin powder of the present invention is excellent in ductility or formability, spherical shape can be relatively easily processed into a flaky shape.

Step b: This step prepare a tin solution for deposition by substitution with temperature at 30-deg. C to 80-deg. C by adding an acid to a aqueous mixture solution containing 0.01-mol/L to 1-mol/L of a stannous salt and 0.1-mol/L to 10-mol/L of thiourea to arrange pH at 0.1 to pH 2.

It is particularly preferable to use stannous tin as a "stannous salt" here. And when the addition amount thereof is less than 0.01-mol/L, the reaction is hard to proceed and the reaction efficiency cannot be increased. Meanwhile, even when the addition amount is more than 1-mol/L, the reaction efficiency does not increase, and the reaction proceeds rather heterogeneously with severe particles aggregation, so it is waste of resources.

The "thiourea" is a complexing agent for tin deposit by substitution. It exhibits a smoothing effect of the surface of the obtained tin powder particles and functions as a copper dissolution promoter at the same time. Therefore, an appropriate addition concentration of thiourea is a concentration necessary for forming a tin powder as the lowest, and a concentration sufficient to perform as a copper dissolution promoter. More specifically, the appropriate addition concentration is 0.1-mol/L to 10-mol/L. When the concentration is less than 0.1-mol/L, the reaction is hard to proceed. In contrast, the amount more than 10-mol/L is excess for complexation of tin supplied from the above stannous salt, thereby the reaction efficiency does not increase, so it is waste of resources.

As the "acid" , acids such as tartaric acid, ascorbic acid, hydrochloric acid and sulfuric acid can be used. Particularly, tartaric acid, ascorbic acid and sulfuric acid are excellent in a function as an oxidizer to dissolve the copper powder, dissolving the oxidized copper powder quickly and performing substitution reaction quickly, so any one selected from them can be used preferably.

When these acids are used, pH of the solution is important, and if the value is too high, rapid dissolution of the surface of the copper powder is hard to proceed and progress of the substitution reaction might be slow. In contrast, when the acid concentration is too high, the dissolution rate of the copper powder and the deposition rate of tin may be out of balance, causing an ununiform dissolution state of the copper powder as a starting raw material or causing troubles in the substitution reaction. As a result, the tin powder is extremely easy to aggregate and therefore tin powder having a uniform particle size distribution cannot be obtained.

The appropriate range of the above acid concentration varies depending on the kind of the acid, but when tartaric acid is used, 0.1-mol/L to 5-mol/L is preferable. When the acid concentration is less than 0.1-mol/L, the reaction is hard to proceed. In contrast, the acid concentration of more than 5-mol/L does not increase the reaction efficiency, and therefore cheep tin powder cannot be obtained, so it is waste of resources.

In Step b, pH at the time of adding an acid to an aqueous mixture solution containing a stannous salt and thiourea is managed to be 2 or below. Preferably, pH is 0 to 2. By adjusting pH to "2 or below", the dissolution of the copper powder which is a starting raw material could be stable and it allows the substitution reaction proceed fast. As a result, tin powder having a uniform particle size distribution can be obtained. In contrast, when pH is "less than 0.1", the dissolution rate of the copper powder and the deposition rate of tin might be out of balance. As a result, uneven tin powder may be obtained.

In addition, in order to cause the substitution reaction using anyone of the above described solution, the solution temperature is adjusted in the range of 30-deg. C to 90-deg. C and the solution is sufficiently agitated. If the solution temperature is lower than 30-deg. C, it results lower substitution rate of tin and longer reaction time, and the productivity industrially required is not satisfied. In contrast, when the solution temperature exceeds 90-deg. C, it results the substitution rate of tin too high, irregularity of the particle surface big, the tin powder is extremely easy to aggregate and therefore tin powder having a uniform particle size distribution cannot be obtained.

Step c: This step perform deposition of tin by substitution by mixing the copper powder slurry obtained in the Step a with the tin solution for deposition by substitution obtained in the Step b. In the step, the mixture in which the ratio of tin per 1-mol of copper in the above copper powder slurry is arranged to be 0.4-mol to 1-mol is agitated to perform deposition of tin by substitution. The tin solution for deposition by substitutionmaybe added at once, or added slowly with constant addition rate. However, in order to stabilize a dissolution of the copper powder of a starting raw material, slow addition over 10 minutes ormore is preferable and addition over 1 hour or more is more preferable. In order to increase contact (reaction) chance and reaction over the whole system be even, it is preferable to disperse well among the solution.

It is preferable to add and mix a tin solution for deposition by substitution to a copper powder slurry separately in plural times in the reaction of a copper powder slurry with a tin solution for the deposition by substitution. The reason why the tin solution for deposition by substitution is mixed in plural times while agitating in this way is to maintain a stable dissolution of the copper powder and to control the substitution rate of copper powder with tin. It allows the substitution reaction to proceed while maintaining the fine and the sharp particle size distribution as a starting raw material powder characteristic. When the mixing is performed at once, reaction may proceeds heterogeneously due to uneven distribution of temperature and/or pH in the reaction solution tank and results the aggregation of the particles severe.

Preferably, when the solution is separately mixed, it is preferable to add in three times or more. It is considered that the particle size distribution of the tin powder becomes more uniform as the number of times increases, but it is judged to be around 6 times at most in consideration of increase in cost for the production.

In addition, it is also preferable to deposit tin by substitution while applying vibration of ultrasound to the slurry in which the substitution reaction proceed. The reason is that the applying vibration of ultrasound to the fine powder which is easy to aggregate in the solution enables the generated tin powder to be dispersed without aggregation any time . Then the surface of the copper powder on the way to substitution can be continuously exposed to the reaction solution thereby to achieve uniform processing for deposition by substitution.

### <Mixed metal powder containing tin powder of the present invention and the other metal powder>

Tin component mainly consists the tin powder of the present invention has low melting point. Therefore, when processing is performed to make a conductive paste containing the tin powder of the present invention alone and the paste is used for forming a connection in the via holes, after processing to remove the organic agent in the paste, cavities might be resulted even they are filled up with the tin powder no matter how the filling abilities in the via hole have been improved, and if the particles of the tin powder bond by fusing with each other, dimensional change may occur. Thus, there is naturally limitation in keeping dimensional stability satisfactorily as a conductor.

Therefore, tominimize the dimensional change of the basic shape of the connection even when deformation is caused in bonding by fusing of the tin powder at the time of heating, mixing of the other powder such as copper powder and/or silver powder having high melting points make it easy to secure stability of the conductor shape as compared with the case that the tin powder having a low melting point is used at 100%. In addition, it is also preferable in that connection such as via holes having a lower resistivity can be formed by using copper powder and/or silver powder and the like having a higher melting point and a lower electric resistance than tin powder.

Furthermore, the mixing ratio of the tin powder of the present invention with the other powder such as copper powder does not need to be limited in particular. It is preferable to contain 50 wt% or more of the tin powder of the present invention as a result of intensive studies by the present inventors. When tin powder is less than 50 wt%, when processed it into a conductive paste, melt tin powders cannot connect the particles of the other powder in the formed conductors such as via holes and has tendency to fail securing the mechanical strength, so it is not preferable.

### <Conductive paste containing tin powder of the present invention and the above mixture of metal powders>

Tin powder of the present invention and the above mixture metal powders are processed into a conductive paste by mixing them with organic agents, and they are used for the formation of conductive parts such as for the formation of electrodes in chip devices, circuit formation of the printed wiring boards and formation of the via holes. By using the conductive paste of the present invention, formation of a conductor accurate in the thickness, width or the straightness of a circuit can be performed which could not be formed with conventional tin powder and solder powder.

Hereinafter, Examples according to the present invention and Comparative Example are described. For the convenience of the following description, Table 1 to Table 5 are shown first. Here, Table 1 to Table 4 show production conditions in Example 1 to Example 4 and Table 5 shows results on the powder properties of both base powder (copper powder) and tin powder obtained in Example 1 to Example 4 and Comparative Example.

The investigation method of various items of the powder properties in Table 5 is described one by one from the left side item.

"D_{IA}" is a value determined by image analysis (taken at 2,000 times to 10,000 times magnification in the present application (see figures described later)) by circle particle analysis using IP-1000PC manufactured by Asahi Engineering Co., Ltd. and assuming the circle degree threshold to be 50 to 70, and the overlapping degree to be 50 on the image observed on the spherical tinpowderwith a scanning electron microscope (SEM) (In this Example, N = 30).

"D_{IAF}" is an average value of the major axis diameter (micron meter) of tin powder measured from SEM images (In this Example, N = 30).

"SD" is a standard deviation statistically obtained from the independently observed values on "D_{IA}" and "D_{IAF}" of the tin powder particles from SEM images.

"SD/D_{IA}" or "SD /D_{IAF}" is value obtained by dividing "SD" by "D_{IA}" or "D_{IAF}" respectively.

The "maximum particle diameter" is a maximum particle diameter obtained at the time of above image analysis of spherical tin powder observed with a scanning electron microscope (SEM).

The "minimum particle diameter" is a minimum particle diameter obtained at the time of above image analysis of spherical tin powder observed with a scanning electron microscope (SEM).

"Range" is a difference between the above "maximum particle diameter" and the above "minimum particle diameter".

"Range/D_{IA}" or "Range/D_{IAF}" is value obtained by dividing the above "Range" by "D_{IA}" or by dividing the above range by "D_{IAF}" respectively.

**[Table 1]**

| | Cu slurry | | | Tin solution for deposition by substitution | | | | | | | | | | | Molar ratio of Sn/Cu of |
|---|---|---|---|---|---|---|---|---|---|---|---|---|---|---|---|
| | Amount of Cu g | Volume L | Concentration mol/L | Total Volume L | Tin chloride (dehydrate) | | | Thiourea | | | Tartaric acid | | | Solution pH | |
| | | | | | g | mol | mol/L | g | mol | mol/L | g | mol | mol/L | | |
| Example 1 | 500 | 20 | 0.39 | 15 | 789 | 3.50 | 0.23 | 7245 | 95.20 | 6.35 | 5133 | 34.22 | 2.28 | 1.1 | 0.44 |

**[Table 2]**

| | Cu slurry | | | Tin solution for deposition by substitution | | | | | | | | | | | Molar Ratio of Sn/Cu |
|---|---|---|---|---|---|---|---|---|---|---|---|---|---|---|---|
| | Amount of Cu g | Volume L | Concentration mol/L | Total Volume L | Tin sulfate (anhydride) | | | Thiourea | | | 20 wt% sulfuric acid | | | Solution pH | |
| | | | | | g | mol | mol/L | g | mol | mol/L | g | mol | mol/L | | |
| Example 2 | 50 | 1.5 | 0.52 | 4 | 89 | 0.41 | 0.10 | 725 | 9.50 | 2.38 | 70 | 0.14 | 0.04 | 0.6 | 0.53 |

**[Table 3]**

| | Cu slurry | | | Tin solution for deposition by substitution | | | | | | | | | | | Molar ratio of Sn/Cu |
|---|---|---|---|---|---|---|---|---|---|---|---|---|---|---|---|
| | Amount of Cu g | Volume L | Concentration mol/L | Total Volume L | Tin sulfate (anhydride) | | | Thiourea | | | 20 wt% sulfuric acid | | | Solution pH | |
| | | | | | g | mol | mol/L | g | mol | mol/L | g | mol | mol/L | | |
| Example 3 | 50 | 1.0 | 0.79 | 3 | 89 | 0.41 | 0.14 | 725 | 9.50 | 3.18 | 70 | 0.14 | 0.05 | 0.6 | 0.53 |

**[Table 4]**

| | Cu slurry | | | Tin solution for deposition by substitution | | | | | | | | | | | Molar ratio of Sn/Cu |
|---|---|---|---|---|---|---|---|---|---|---|---|---|---|---|---|
| | Amount of Cu g | Volume L | Concentration mol/L | Total Volume L | Tin sulfate (anhydride) | | | Thiourea | | | 20 wt% sulfuric acid | | | Solution pH | |
| | | | | | g | mol | mol/L | g | mol | mol/L | g | mol | mol/L | | |
| Example 4 | 50 | 1.0 | 0.79 | 3 | 89 | 0.41 | 0.14 | 725 | 9.50 | 3.18 | 70 | 0.14 | 0.05 | 0.6 | 0.53 |

**[Table 5]**

| | Kind of powder | D_{IA} (D_{IAF}) | SD | SD/ D_{IA} (SD/ D_{IAF}) | Maximum particle diameter | Minimum particle diameter | Range | Range/ D_{IA} (Range/ D_{IAF}) |
|---|---|---|---|---|---|---|---|---|
| Example 1 | Copper powder (Base powder) | 2.54 | 0.57 | 0.22 | 3.82 | 0.46 | 3.36 | 1.32 |
| | Tin powder (Finished powder) | 2.35 | 0.57 | 0.24 | 3.61 | 0.45 | 3.16 | 1.34 |
| Example 2 | Copper powder (Base powder) | 1.10 | 0.22 | 0.20 | 1.64 | 0.35 | 1.29 | 1.17 |
| | Tin powder (Finished powder) | 1.01 | 0.21 | 0.21 | 1.55 | 0.34 | 1.21 | 1.20 |
| Example 3 | Copper powder (Base powder) | 0.86 | 0.19 | 0.22 | 1.25 | 0.13 | 1.12 | 1.30 |
| | Tin powder (Finished powder) | 0.80 | 0.19 | 0.24 | 1.21 | 0.13 | 1.08 | 1.35 |
| Example 4 | Copper powder (Base powder) | 1.42 | 0.32 | 0.23 | 2.08 | 0.51 | 1.57 | 1.11 |
| | Tin powder (Finished powder) | 1.30 | 0.32 | 0.25 | 2.07 | 0.50 | 1.57 | 1.21 |
| Comparative Example | | 3.64 | 1.57 | 0.43 | 7.61 | 0.45 | 7.16 | 1.97 |

| | | | | | | | | |
|---|---|---|---|---|---|---|---|---|
| (Note) D_{IAF}, SD/D_{IAF}, Range/D_{IAF} is applied only about Example 4 which is a flaky powder. | | | | | | | | |

As for the evaluation items (parameters) by the investigation methods for various characteristics shown in Table 5, description has been given already and therefore repeated description will be omitted here.

### [Example 1]

The tin solution for deposition by substitution used in Example 1 was prepared by dissolving 789 g of stannous dehydrate, 7245 g of thiourea, 5133 g of tartaric acid in pure water, adjusting pH to 1.1, and maintaining the solution temperature at 40-deg. C to make the total volume of 15 L. Meanwhile, 500 g of copper powder was put into 20 L of pure water maintained at 40-deg. C and agitated to prepare a copper powder slurry. While being agitated, 5 L of the tin solution for deposition by substitution was added to the copper powder slurry in one hour, then agitated for 30 minutes while being maintained at 40-deg. C, and then kept still and after that 10 L of the supernatant solution was removed and 10 L of pure water was added thereto in one hour. After the operation (re-pulp rinsing) was performed three times, 5 L of the tin solution for deposition by substitution was further added, and the re-pulp rinsing was repeated, and then 5 L of the tin solution for deposition by substitution was added in one hour (added at three times in total). After that, filtration, rinsing and drying were performed according to a popular method, and a spherical tin powder of Example 1 was obtained.

The powder properties of the tin powder obtained in Example 1 were: D_{IA} = 2.35-micron meter, Dₘₐₓ = 3.61-micron meter, Dₘᵢₙ = 0.45-micron meter, SD = 0.57-micron meter, SD/D_{IA} = 0.22 and Range/D_{IA} = 1.34. The copper content was 1.2 wt% (See Table 5).

### [Example 2]

The tin solution for deposition by substitution used in Example 2 was prepared by dissolving 89 g of tin sulfate (anhydride), 725 g of thiourea, 20 wt% of sulfuric acid in pure water, adjusting pH to 0.6, and maintaining the solution temperature at 40-deg. C to make the total volume of 4 L. Meanwhile, 50 g of copper powder was put into 1.5 L of pure water maintained at 40-deg. C and agitated to prepare a copper powder slurry. While being agitated, 1.3 L of the tin solution for deposition by substitution was added to this copper powder slurry in 1.5 hours, then agitated for 30 minutes while being maintained at 40-deg. C, and then kept still and after that 1.3 L of the supernatant solution was removed and pure water was added thereto three times, and then 1.3 L of the remaining tin solution for deposition by substitution was added in 1.5 hours (added three times in total), agitated for 30 minutes and then kept still, and after that, filtration, rinsing and drying were performed according to a popular method, and a spherical tin powder of Example 2 was obtained.

The powder properties of the tin powder obtained in Example 2 were: D_{IA} = 1.01-micron meter, Dₘₐₓ = 1.55-micron meter, Dₘᵢₙ = 0.34-micron meter, SD = 0.21-micron meter, SD/D_{IA} = 0.21 and Range/D_{IA} = 1.20. The copper content was 0.2 wt% (See Table 5).

### [Example 3]

The tin solution for deposition by substitution used in Example 3 was prepared by dissolving 89 g of tin sulfate (anhydride), 725 g of thiourea, 20 wt% of sulfuric acid in pure water, adjusting pH to 0.6, and maintaining the solution temperature at 40-deg. C to make the total volume of 1 L. Meanwhile, 50 g of copper powder was put into 10 L of pure water maintained at 40-deg. C and agitated to prepare a copper powder slurry. While being applied with vibration of ultrasound (a ultrasonic cleaner of model CA-4488Z (frequency 38 kHz) manufactured by Kaijo Co., Ltd. was used. Same in below.), the tin solution for deposition by substitution was added to this copper powder slurry in 2 hours to perform deposition by substitution reaction, agitated for 30 minutes and then kept still and after that, filtration, rinsing and drying were performed according to a popular method, and a spherical tin powder of Example 3 was obtained.

The powder properties of the tin powder obtained in Example 3 were: D_{IA} = 0.80-micron meter, Dₘₐₓ = 1.21-micron meter, Dₘᵢₙ = 0.15-micron meter, SD = 0.19-micron meter, SD/D_{IA} = 0.24 and Range/D_{IA} = 1.35. The copper content was 0.5 wt% (See Table 5).

### [Example 4]

The tin solution for deposition by substitution which was used in Example 4 was prepared by dissolving 89 g of tin sulfate (anhydride), 725 g of thiourea, 20 wt% of sulfuric acid in pure water, adjusting pH to 0.6, and maintaining the solution temperature at 40-deg. C to make the total volume of 1 L. Meanwhile, 50 g of flaky copper powder as a starting raw material was put into 10 L of pure water maintained at 40-deg. C and agitated to prepare a copper powder slurry. While being applied with vibration of ultrasound, the tin solution for deposition by substitution was added to this copper powder slurry in 2 hours to perform deposition by substitution reaction, agitated for 30 minutes and then kept still and after that, filtration, rinsing and drying were performed according to a popular method, and a spherical tin powder of Example 4 was obtained.

The powder properties of the tin-coated copper powder obtained in Example 4 were: D_{IAF} = 1.30-micron meter, Dₘₐₓ = 2.07-micron meter, Dₘᵢₙ= 0.50-micron meter, SD = 0.32-micron meter, SD/D_{IAF} = 0.25 and Range/D_{IA} = 1.21, aspect ratio = 4.4. The copper content was 0.05 wt% (See Table 5).

### [Comparative Example]

The Comparative Example is a tin powder obtained by conventional atomization process. The powder properties of the tin powder were:
D_{IA}= 3.64-micron meter, SD = 1.57-micron meter, Dₘₐₓ = 7.61-micron meter, Dₘᵢₙ = 0.45-micron meter, SD/D_{IA} = 0.43 and Range/D_{IA} = 1.97.

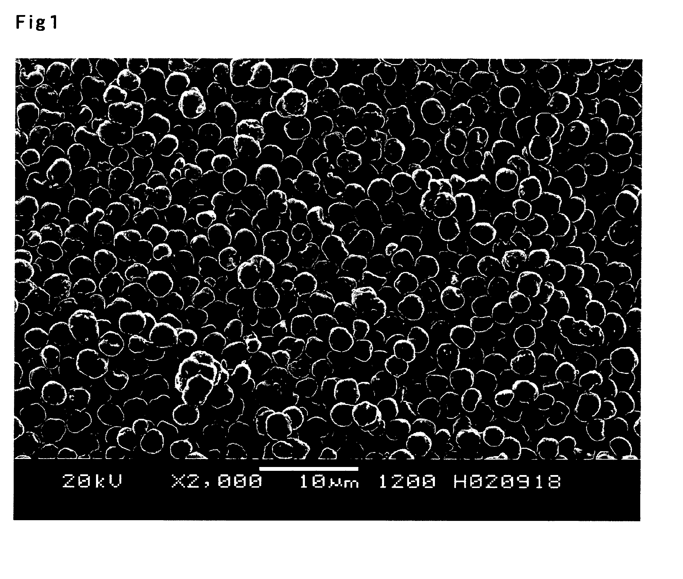

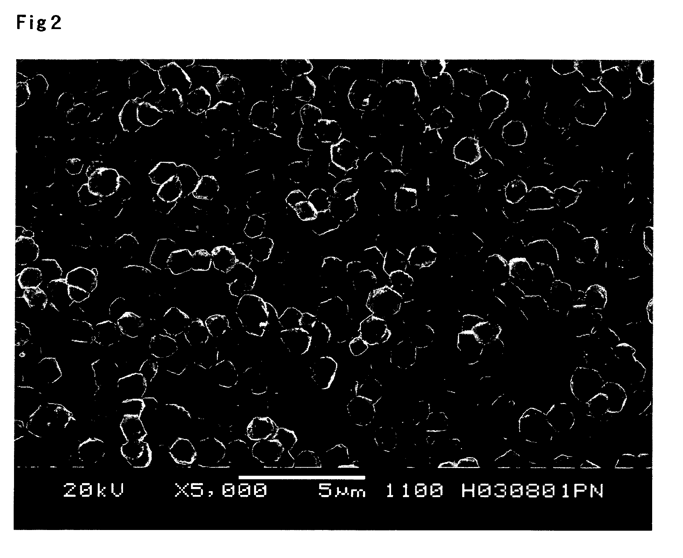

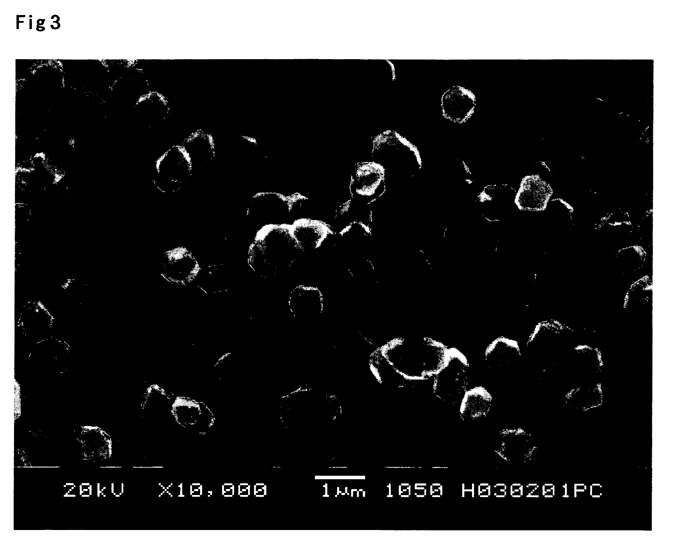

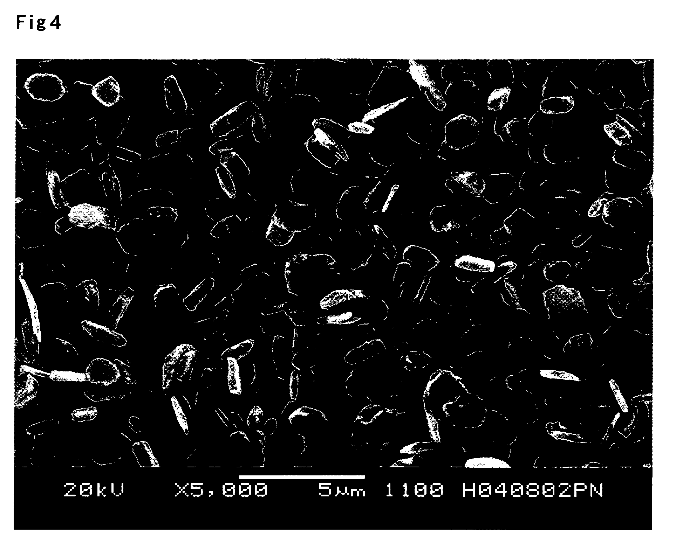

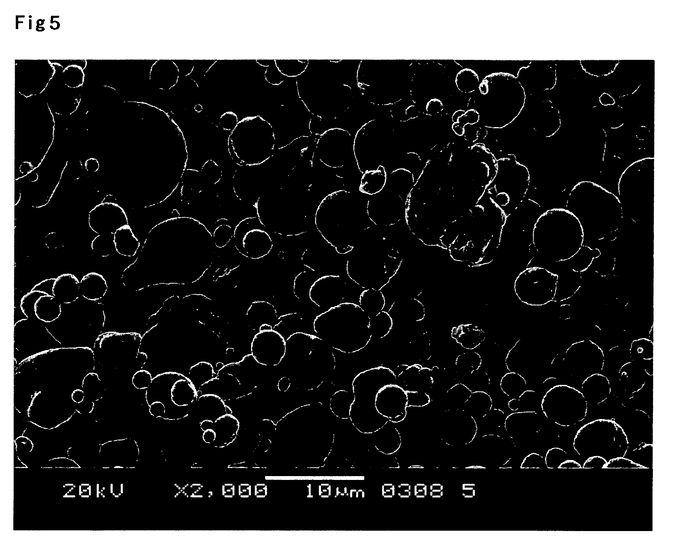

SEM images of the spherical tin powders of the above-described Example 1 to Example 4 were shown in Figure 1 to Figure 4. SEM image of the tin powder by the atomization process of Comparative Example is shown in Figure 5.

### <Total performance>

As shown above, in view of SEM images and statistical data, tin powders of Example 1 to Example 4 according to the present invention are consisted of fine particles and they had powder properties with sharp particle size distribution as compared with the tin powder by the atomization process of Comparative Example in view of the values of SD, SD/D_{IA}, SD/D_{IAF} and Range.

### Industrial Applicability

The tin powder of the present invention can be used in the field in which the filling of small via holes and the formation of fine conductive part (wiring part) are required.

## Claims

1. A tin powder comprising spherical particles usable as a substitute for solder powder **characterized in that** D_{IA} is 0.1-micron meter to 3-micron meter and SD/D_{IA} is 0.1 to 0.3
(wherein D_{IA} is an average value (average particle diameter) of particle diameters (micron meter) of tin powder measured from SEM images; SD is a standard deviation statistically obtained from the respectively measured values of the tin powder particles in SEM images (herein after same) ; SD/D_{IA} is a coefficient of variation which indicates sharpness or broadness of the particle size distribution).

2. The tin powder comprising spherical particles according to claim 1 **characterized in that** the value obtained by dividing the difference between the maximum particle diameter and the minimum particle diameter (range) by D_{IA} is 0.3 to 1.6.

3. A tin powder comprising flaky particles usable as a substitute for solder powder **characterized in that**
D_{IAF} is 0.1-micron meter to 5-micron meter and SD/D_{IAF} is 0.15 to 0.4
(wherein D_{IAF} refers to an average value of the major axis diameters (micron meter) of tin powder measured from SEM images; SD/D_{IAF} refers to a coefficient of variation which indicates sharpness or broadness of the particle size distribution).

4. The tin powder comprising flaky particles according to claim 3 **characterized in that** the value obtained by dividing the difference between the maximum particle diameter and the minimum particle diameter (range) by D_{IAF} is 0.3 to 1.6.

5. The tin powder comprising flaky particles according to claim 3 or claim 4 **characterized in that** the average aspect ratio of the tin powder particles is 2 to 10.

6. A manufacturing method of the tin powder according to any of claim 1 to claim 5 **characterized by** comprising the following Step a to Step c.
Step a: prepare a copper powder slurry having a dispersed copper concentration of 0.05-mol/L to 2-mol/L by adding a copper powder in water with agitation;
Step b: prepare a tin solution for deposition by substitution with temperature at 30-deg. C to 80-deg. C by adding an acid to a aqueous mixture solution containing 0.01-mol/L to 1-mol/L of a stannous salt and 0.1-mol/L to 10-mol/L of thiourea to arrange pH at 0.1 to pH 2; and
Step c: perform deposition of tin by substitution by mixing the copper powder slurry and the tin solution in the ratio of tin 0.4-mol to 1-mol against 1-mol of copper in the above copper powder slurry for deposition by substitution while dispersing and agitating.

7. The manufacturing method of the tin powder according to claim 6, wherein the operation of mixing the above tin solution to above copper powder slurry for deposition by substitution while agitating is separately performed in plural times in the Step c.

8. The manufacturing method of tin powder according to claim 7, wherein the plural times are three times or more.

9. The manufacturing method of tin powder according to any of claim 6 to claim 8, wherein tin is deposited by substitution while applying vibration of ultrasound to the reaction slurry in the Step c.

10. A powder mixture **characterized in that** the tin powder according to any one of claim 1 to claim 5 and powder of a conductive metal other than tin is mixed.

11. A conductive paste **characterized by** containing the tin powder according to any one of claim 1 to claim 5.

12. A conductive paste **characterized by** containing the powder mixture according to claim 10.
